# EUROPEAN PATENT APPLICATION

(11) **EP 3 131 112 A1**
(43) Date of publication of application: **15.02.2017**
(21) Application number: 15180793.0
(22) Date of filing: 12.08.2015
(51) Int. Cl.: H01L 21/28, H01L 21/268, H01L 21/329, H01L 29/16

(54) **METHOD FOR FORMING AN OHMIC CONTACT ON A BACK-SIDE SURFACE OF A SILICON CARBIDE SUBSTRATE**

(71) Applicant: Laser Systems & Solutions of Europe, 92230 Gennevilliers (FR)
(72) Inventor: MAZZAMUTO, Fulvio, 75018 Paris (FR)
(74) Representative: Chauvin, Vincent

(57) **Abstract**

The invention relates to a method for forming an ohmic contact on a back-side surface of a silicon carbide substrate (1) comprising the steps of:
a) depositing on said back-side surface a precursor layer (5) containing a transition metal;
b) irradiating said precursor layer (5) with a laser pulse (6) so as to form a silicide layer on the back-side surface of the silicon carbide substrate, said ohmic contact being formed at an interface between said silicide layer and said back-side surface of the silicon carbide substrate.

According to the invention, the precursor layer deposited in step a) has a molecular content in silicon of at most 1 %, irradiation of on the back-side surface of the silicon carbide substrate in step b) causing the whole precursor layer and a superficial layer (7) of silicon carbide substrate to melt and mix to form said silicide layer.

## Description

### TECHNICAL FIELD OF THE INVENTION

The invention relates to the domain of microelectronics and of semiconductor manufacturing.

More precisely the invention relates to a method for forming an ohmic contact on a back-side surface of a silicon carbide substrate by laser thermal annealing.

### BACKGROUND INFORMATION AND PRIOR ART

It is known from an article of Rupp et al. (hereinafter referred to as Rupp), entitled "Laser backside contact annealing of SiC power devices: a prerequisite for SiC thin wafer technology" (in Proceedings of the 25th International Symposium on Power Semiconductor Devices & ICs, held in Kanazawa, Japan on May 26-30, 2013), a method for forming an ohmic contact on a back-side surface of a silicon carbide substrate comprising the steps of:
a) depositing on said back-side surface a precursor layer containing a transition metal;
b) irradiating said precursor layer with a laser pulse so as to form a silicide layer on the back-side surface of the silicon carbide substrate, said ohmic contact being formed at an interface between said silicide layer and said back-side surface of the silicon carbide substrate.

At step a) of the method of Rupp, the precursor layer containing a transition metal is a layer of nickel silicide (NiSi) which is obtained by sputtering both nickel and silicon on the back-side surface of the silicon carbide substrate.

At step b) of the method of Rupp, the precursor layer is thermally annealed with a XeCl pulsed laser and the nickel silicide layer is reformed.

Rupp then shows that the ohmic contact formed at an interface between said silicide layer and said back-side surface of the silicon carbide substrate presents a contact resistance lower than 10⁻⁵ Ohm/cm².

Nevertheless, the operation of sputtering both nickel and silicon, with the good stoichiometric proportions is very complex and expensive. Moreover, such operation is not standard in the manufacturing process of silicon carbide devices.

Using such method in the fabrication of semiconductor devices having back-side ohmic contacts may further compromise the yield.

### SUMMARY OF THE INVENTION

Therefore one object of the invention is to provide a method for forming an ohmic contact on a back-side surface of a silicon carbide substrate which is easy and not expensive to implement in the industry of semiconductor manufacturing.

A further object of the invention is to provide a method for forming an ohmic contact that does not need sputtering both a transition metal and silicon to form the precursor layer.

Another object of the invention is to provide a method for forming an ohmic contact on the back-side surface of a silicon carbide substrate without damaging the front-side surface of the substrate, which can comprise various circuitry elements.

Another object of the invention is to provide a method for forming an ohmic contact which is reliable and presents a very high yield.

Another object of the invention is to provide a method for forming an ohmic contact having very good contact resistance properties.

The above objects are achieved according to the invention by providing a method for forming an ohmic contact on a back-side surface of a silicon carbide substrate as defined herein above, wherein the precursor layer deposited in step a) has a molecular content in silicon of at most 1 %, irradiation on the back-side surface of the silicon carbide substrate in step b) causing the whole precursor layer and a superficial layer of silicon carbide substrate to melt and mix to form said silicide layer.

In the method according to the invention, the metal-silicide layer is formed with the transition metal contained in the precursor layer and with the silicon coming from the superficial layer of the silicon carbide molten by the laser pulse.

Thus, with the method according to the invention, there is no need to deposit a NiSi layer on top of the back-side surface of the silicon carbide substrate to bring the silicon atoms needed for the formation of the metal-silicide layer.

Preferably, the molecular content in silicon of the precursor layer is zero. In other words, the precursor layer does not contain silicon at all.

According to another aspect of the invention, the molecular content in transition metal of the precursor layer is higher or equal to 90%, higher or equal to 95%, better higher or equal to 99%.

Advantageously, the molecular content in transition metal of the precursor layer is 100%, that is that the precursor layer is a transition metal layer, containing only a transition metal.

This transition metal may be nickel, titanium, aluminum, or platinum.

Alternatively, the transition metal deposited at step a) may enter in the composition of a metallic alloy. Hence, the precursor layer is then formed by a layer of the metallic alloy comprising the transition metal.

According to another aspect of the invention, the method further comprises an additional deposition step before step b) wherein at least one additional layer is deposited on top of said precursor layer or between said precursor layer and said back-side surface of the substrate. In the case where the at least one additional layer is deposited on top of the precursor layer, the laser pulse irradiates this additional layer.

According to other non-limiting and advantageous features of the method according to the invention:
- in step b) the energy density, the pulse duration, and/or the laser wavelength of said laser pulse is/are adjusted to melt said superficial layer of silicon carbide substrate to a pre-determined thickness;
- the method comprises a step of determining a melting depth of the molten precursor and superficial layers;
- the method comprises before step a) a step of forming a rough damaged silicon carbide layer on said back-side surface of the silicon carbide substrate, said precursor layer being deposited on said damaged silicon carbide layer and said superficial layer comprising at least said damaged silicon carbide layer;
- said damaged silicon carbide layer has a thickness comprised between 1 nm and 500 nm, preferably between 100 nm and 300 nm;
- said damaged silicon carbide layer has a roughness below 100 nm;
- before step b) the deposited precursor layer has a thickness comprised between 10 and 100 nm, preferably between 50 and 200 nm;
- the silicide layer formed at the end of step b) is a non-stoichiometric metal-silicide layer, for example a nickel-silicide layer or a titanium-silicide layer;
- the energy density of said laser pulse is greater than 1 J/cm², preferably 3J/cm²;
- the pulse duration of said laser pulse is comprised between 50 and 200 ns, preferably between 130 and 180 ns;
- the laser wavelength of said laser pulse is in the UV, preferably between 250 and 355 nm;
- the laser pulse is irradiated by an excimer laser;
- the laser pulse presents a geometrical section greater than 100 mm², preferably greater than 200 mm²;
- the step of irradiating said back-side surface comprises irradiating at least two selected regions of said back-side surface with only one laser pulse for each selected region;
- said two selected regions overlap by at most 1 %.

The invention also concerns the use of such method for forming an ohmic contact in order to make silicon carbide vertical devices, such as a Schottky-barrier diode, a junction-field-effect transistor, a metal-oxide semiconductor field-effect transistor, an insulated-gate bipolar transistor, or a thyristor.

### DETAILED DESCRIPTION OF EXAMPLES

The following description, given with regard to the appended drawings and by way of non-limiting example, will allow the invention and how it may be implemented to be better understood.

In the appended drawings:
- figure 1 represents schematically a substrate of silicon carbide having a circuitry layer on its front-side;
- figures 2 to 4 illustrate different steps of a first embodiment of a method for forming an ohmic contact on the back-side surface of the silicon carbide substrate of figure 1;
- figure 5 shows a Schottky-barrier diode comprising an ohmic contact formed by the method illustrated in figures 1-4;
- figure 6 represents the temperature reached by the precursor layer and the back-side surface of the substrate as a function of the energy density of the laser pulse irradiating the precursor layer;
- figure 7 represents a X-ray diffraction measurement curve of a silicon carbide substrate covered by a metal-silicide layer formed by the method illustrated in figures 1-4;
- figure 8 represents a silicon carbide substrate with a rough damaged silicon carbide layer and a rough precursor layer on top of the damaged layer;
- figure 9 represents the substrate of figure 8 after irradiation with a laser pulse;
- figure 10 depicts a laser apparatus for irradiating a silicon carbide substrate and forming a metal-silicide layer on this substrate; and
- figure 11 shows a silicon carbide wafer with different regions to be irradiated and the laser pulse beam spots irradiating those regions.

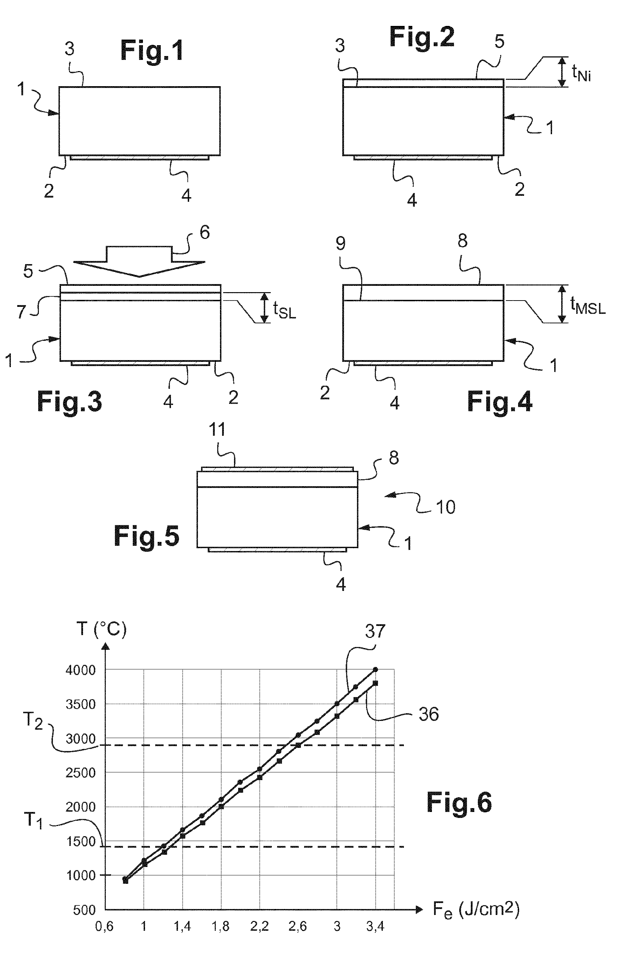

Figures 1 to 5 represent schematically the different steps involved in the manufacturing of a high-power Schottky-barrier diode 10 using a silicon carbide (hereinafter designated with its chemical formula SiC) substrate 1 (or *wafer).*

This Schottky-barrier diode 10 is a kind of silicon carbide vertical devices. In opposition to *"horizontal"* devices, vertical devices are microelectronic devices where the current of electrons flows across the substrate, from one side to the other of the substrate, substantially in a transverse direction.

The substrate 1 is here a α-SiC substrate, and more precisely a moissanite 4H-SiC crystalline type.

Alternatively, the substrate may be a 6H-SiC (α) or a β-type crystallike 3C-SiC.

As depicted on figure 1, the substrate 1 comprises a front-side surface 2 and a back-side surface 3, the designations *"front-side"* and *"back-side"* being well established in the microelectronics industry.

A contact layer 4 of metal, like nickel, platinum, titanium or aluminum for example, or of metal alloy like nickel-gold, nickel-tungsten or nickel-silver is deposited on the front-side surface 2 of the SiC substrate 1 of the Schottky-barrier diode 10. The function of the contact layer 4 is to serve as an anode for the diode 10 to inject current into the device.

Figures 2 to 4 relate more particularly to a first embodiment of the method according to the invention for forming an ohmic contact on the back-side surface 3 of the SiC substrate 1.

In this first embodiment, the back-side surface 3 of the substrate 1 is a polished face.

In a first step (step a), illustrated on figure 2, a precursor layer 5 is deposited on the back-side surface 3 of the substrate 1. This layer is here called *"precursor layer"* because, as it will be understood hereafter (see figure 4), it enters in the fabrication of the metal-silicide layer 8 needed for the formation of the ohmic contact.

And, this precursor layer 5 contains a transition metal, which brings the metallic element for the metal-silicide layer 8. The transition metal may be selected among nickel, titanium, aluminum, or platinum.

In a second step (step b), depicted in figures 3 and 4, a laser pulse 6 (represented as an arrow) is irradiated on the precursor layer 5, on the back-side of the substrate 1 and, after heating and cooling, a silicide layer 8 on the back-side surface 3 of the SiC substrate 1 is formed.

The ohmic contact of the Schottky-barrier diode 10 is formed at an interface 9 between the silicide layer 8 and the substrate 1.

According to the invention, the precursor layer 5 deposited in step a) has a molecular content in silicon of at most 1 %, and the irradiation with the laser pulse 6 on the back-side surface 3 of the SiC substrate 1 in step b) causes the whole precursor layer 5 and a superficial layer 7 (see figure 3) of SiC substrate 1 to melt and mix to form the silicide layer 8.

In the various embodiments described in the present application, the precursor layer 5 is a nickel layer (i.e. transition metal is nickel), having a molecular content in nickel of at least 99%. The precursor layer 5 does not contain silicon at all, that is that the molecular content in silicon is zero. In other words, in step a) no deposition of silicon is made at the same time as nickel.

By the way, the precursor layer 5 of nickel may be deposited on the back-side surface 3 of the substrate 1 by sputtering, evaporation, electroplating.

In a variant, the transition metal of the precursor layer deposited at step a) of the method enters in the composition of a metallic alloy. The metallic alloy may be for example an alloy containing the transition metal and gold, silver or aluminum for example. Thus, when the transition metal is nickel, the metallic alloy may be nickel-gold, nickel-silver, or nickel-aluminum. In this variant, the precursor layer deposited on the back-side surface of the substrate is then formed by a layer of the metallic alloy comprising this transition metal (e.g. nickel).

After step a) (deposition) and before step b) (irradiation), the deposited precursor layer 5 has, in the first embodiment represented on figure 2, a thickness t_{Ni} of 100 nm.

In the method according to the invention, the laser pulse 6 heats to a very high temperature not only the top thin precursor layer 5 containing the transition metal but also the superficial layer 7 of the SiC substrate 1. Hence, thanks to the laser pulse 6, both the precursor layer 5 (over its entire thickness t_{Ni}) and the superficial layer 7 are changed from a solid state to a molten phase, these layers 5, 7 being in this molten and liquid phase during a period of time, referred to as *melting time* (denoted hereinafter Tₘₑₗₜ).

As shown on figure 3, this superficial layer 7 is located on the back-side of the substrate 1, and corresponds to a layer starting just below the back-side surface 3 of the substrate 1 which is in contact with the precursor layer 5.

Basically, the superficial layer 7 corresponds to the part of the SiC substrate 1 whose temperature is sufficiently raised by the heating of the laser pulse 6 to be above the melting temperature of silicon carbide, which is around 2700-3000°C.

Advantageously, in a preferred embodiment, the energy density, the pulse duration, and/or the laser wavelength of the laser pulse 6 is/are adjusted to melt the superficial layer 7 of the SiC substrate 1 to a pre-determined thickness t_{SL} (see figure 3).

Depending on the temperature gradient established in the substrate 1 through heating by the laser pulse 6, this pre-determined thickness t_{SL} of the superficial layer 7 may be comprised between 10 nm and 1 µm. Typically, for microelectronics application, the pre-determined thickness t_{SL} varies in the range from 300 nm to 500 nm.

In various embodiments of the method for forming a ohmic contact according to the invention, the energy density of the laser pulse 6 is greater than 1 J/cm², preferably greater than 3 J/cm².

The energy density, noted Fₑ, corresponds actually to the fluence of the laser pulse 6, which is the quantity of energy (J) per pulse and per unit of area (m²). The fluence Fₑ is generally expressed in Joules per square centimeter (J/cm²).

By way of example, figure 6 represents two curves 36, 37 corresponding, respectively, to the temperatures reached by the 100 nm thick Ni precursor layer 5 (curve 36) and by the back-side surface 3 of the substrate 1 (curve 37) as a function of the energy density Fₑ of the laser pulse 6 irradiating the precursor layer 5.

Temperatures T₁ and T₂ on the figure 6 (see ordinates and horizontal dashed lines) are the respective melting temperatures of nickel (Ni) precursor layer 5, and silicon carbide (SiC) superficial layer 7: T1 ≈ 1450°C; T₂ ≈ 2850°C. Above those temperatures, the material is in a molten (liquid) phase; below, it is solid.

As shown on figure 6, an energy density Fₑ greater than 2.6 J/cm² is required in order to melt the 100 nm precursor layer 5 (which is molten from 1450°C) and the SiC substrate (temperature around 3350°C, above melting point of SiC). Experiments show that with a laser pulse of 3 J/cm², the thickness t_{SL} of the superficial layer 7 of silicon carbide ranges between 100 nm and 500 nm.

The melting time Tₘₑₗₜ and the thickness t_{SL} of the superficial layer 7 may also be adjusted by optimizing the pulse duration, noted D_{L} of the laser pulse 6.

In different embodiments, the pulse duration D_{L} is chosen to be comprised between 50 and 200 ns, preferably between 130 and 180 ns.

Advantageously, the laser pulse 6 is irradiated in the ultra-violet region with a wavelength λ_{L} comprised between 190 nm and 400 nm, preferably between 250 and 355 nm.

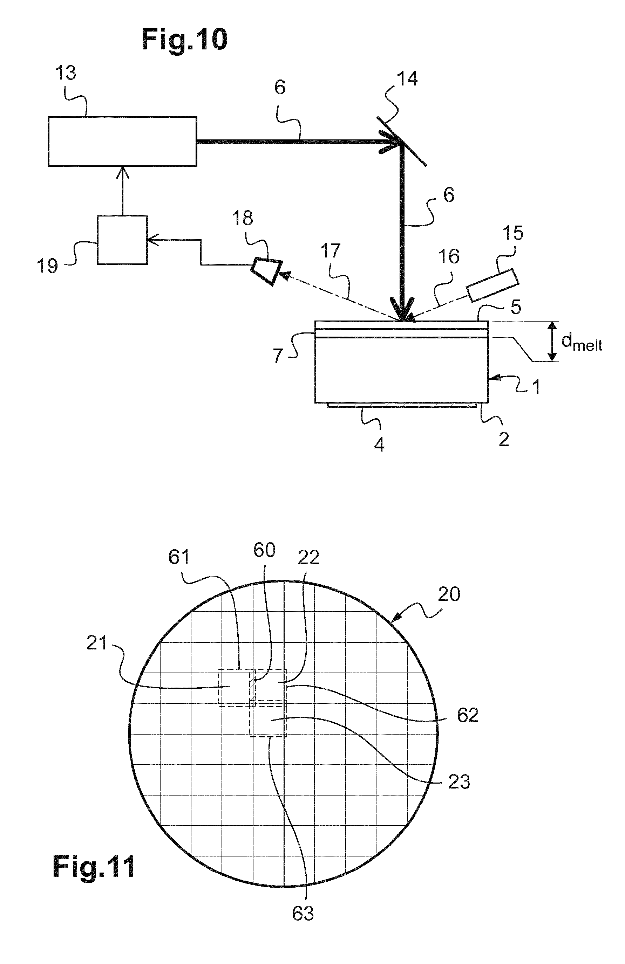

In a preferred embodiment, the laser pulse 6 is irradiated by an excimer laser 13 (see figure 10), for example a Xenon Chloride (XeCl) laser emitting in the UV at a wavelength λ_{L} of 308 nm.

In a particular embodiment of the method according to the invention, one determines a melting depth dₘₑₗₜ of the molten precursor and superficial layers 5, 7. The melting depth dₘₑₗₜ corresponds (see figure 10) to the sum of the thickness t_{Ni} of the precursor layer 5 and of the thickness t_{SL} of the superficial layer 7, when those two layers are in their molten state.

The determination of the melting depth dₘₑₗₜ may be done by measuring the melting time Tₘₑₗₜ which corresponds to the duration of the melting phase, i.e. the period of time during which the precursor layer 5 and the superficial layer 7 are molten.

The duration of this melting phase may be determined by monitoring the variation in the reflectivity on the back-side of the substrate 1. Variations in the reflectivity is linked to a change of the optical refractive indices of the precursor layer 5 and the superficial layer 7 when those layers, initially in a solid state, melt with heating by the laser pulse 6, and then re-solidifies after cooling.

The reflectivity on the back-side of the substrate 1 may be monitored using a reflection intensity measurement.

The melting depth dₘₑₗₜ is determined based on the melting time Tₘₑₗₜ and known characteristics of the precursor layer 5 and superficial layer 7.

For example, the melting time Tₘₑₗₜ, the irradiation parameters of the laser pulse 6 such as energy density, pulse shape, as well as optical and thermal characteristics of the precursor layer 5 and superficial layer 7 may be put into a thermal modeling tool to determine the melting depth dₘₑₗₜ. This may be done either by real-time calculation or by using a look-up table which links melting time Tₘₑₗₜ to melting depth dₘₑₗₜ and which is defined prior to the processing of the substrate 1.

Knowing the thickness t_{Ni} of the precursor layer 5, the thickness t_{SL} of the superficial layer 7 may be deduced from the melting depth dₘₑₗₜ, allowing to monitor the thickness t_{SL} of the superficial layer 7 and control the laser irradiation parameters like energy density, pulse duration, pulse shape and/or repetition rate so as to reach the pre-determined thickness t_{SL}.

The laser irradiation parameters of the laser pulse 6 may be adapted based on comparing the determined melting depth dₘₑₗₜ to a target depth. The target depth may be determined empirically or by modeling based on the required diode 10 performances.

Advantageously, the results of the comparison between the determined melting depth dₘₑₗₜ and the target depth may be easily used in a feedback circuit, resulting in effective stabilization of the irradiation process, and in the method of the invention.

In another embodiment, the determination of the melting depth may be done by using time-resolved interferometry or ellipsometry. In this case, both the thickness of the precursor layer and the thickness of the superficial layer may be measured separately, allowing monitoring independently the thickness t_{SL} of the superficial layer and control the laser irradiation parameters like energy density, pulse duration, pulse shape and/or repetition rate so as to reach the pre-determined thickness t_{SL}.

Figure 10 depicts a laser apparatus for irradiating the silicon carbide substrate 1 and forming the metal-silicide layer on this substrate 1 using the method of the invention. This laser apparatus comprises a first laser 13, here a XeCl excimer laser emitting laser pulses (represented by arrows 6), and a mirror 14 to reflect the laser pulse 6 towards the precursor layer 5 on the back-side of the substrate 1.

The mirror 14 is positioned and oriented so that the laser pulse 6 is reflected in a direction which is substantially perpendicular to the precursor layer 5 (i.e. at normal incidence).

The laser apparatus comprises a XYZ-stage (not shown) supporting the substrate 1 allowing to move the substrate 1 under the laser pulse 6 so as to irradiate a selected region of the precursor layer 5.

The apparatus also includes a reflectivity monitoring unit comprising a second laser 15 for measuring the melting time Tₘₑₗₜ by monitoring the variation in the reflectivity on the back-side of the substrate 1.

This second laser 15 emits a probe beam 16 towards the back-side of the substrate 1, which is reflected at the interfaces between the air and the precursor layer 5 (molten); the precursor layer 5 and the superficial layer 7; and the superficial layer 7 (molten) and the SiC substrate (not molten/solid), into a reflected beam 17 which then collected by a photodetector 18 and analyzed by a command unit 19.

The second laser 15 may be any continuous laser whose wavelength is such that reflectivity changes significantly when the irradiated precursor layer 5 and superficial layer 7 changes from solid to molten state and *vice versa.*

Preferably, the second laser 15 is a continuous laser emitting in the red region of the visible spectrum, for example a continuous laser diode emitting in red. The second laser 15 is directed towards the surface to be treated such that its beam 16 reflects on the surface within the irradiated region irradiated by the first laser 13.

Depending on the changes of intensity of the reflected beam 17 over time, the command unit 19 deduces the melting depth dₘₑₗₜ from the melting time Tₘₑₗₜ, and also the thickness t_{SL} of the superficial layer 7 which is in a molten state. The melting depth dₘₑₗₜ and the thickness t_{SL} of the superficial layer 7 are estimated from the melting time Tₘₑₗₜ using simulation or previous calibration measurement of the thickness t_{SL}.

The command unit 19 controls the first laser 13 so as to adjust the laser irradiation parameters in order that the thickness t_{SL} of the superficial layer 7 reaches a target value.

As explained above, during the melting time Tₘₑₗₜ, both the precursor layer 5 containing the transition metal (here Ni) and the superficial layer 7 of silicon carbide, which contains atoms of silicon, are in a molten phase.

During this phase, the transition metal from the precursor layer 5 and the silicon from the superficial layer 7 mix one with another so as to form a silicide layer 8 (see figure 4), more precisely a metal-silicide layer, here a nickel-silicide layer.

In a variant wherein the precursor layer comprises a metallic alloy containing the transition metal and another metal like gold, silver, or aluminum, both the transition metal and this another metal mix with the molten silicon coming from the silicon carbide substrate so as to form the metal-silicide layer. In this case, depending on irradiation conditions, different phases of metal-silicide are formed during step b).

One advantage of using a high-energy density and short laser pulse 6 is that the intermixing between the transition metal and the silicon is accelerated and the silicide formation reaction is enhanced.

When the heating by the laser 13 stops, that is after the irradiation by the laser pulse 6, this metal-silicide layer 8 cools down and its temperature decreases and falls below its melting temperature T₁ (see fig. 6) so that the metal-silicide solidifies after cooling.

The thickness T_{MSL} (see figure 4) of the metal-silicide layer 8 after cooling may be greater, equal, or lower than the melting depth dₘₑₗₜ.

One advantage of the present method, with a fast and strong heating of the precursor layer 5 and the superficial layer 7, is that the silicide layer 8 formed at the end of step b) is a non-stoichiometric metal-silicide layer.

By *"non-stoichiometric"* metal-silicide layer, we understand a silicide layer 8 comprising at least two different phases of metal-silicide.

The formation of the non-stoichiometric metal-silicide layer 8 is obtained through the melting of a part of the silicon carbide substrate 1, namely the superficial layer 7, which brings the silicon atoms needed for the silicide layer 8, whereas the atoms of transition metal (here Ni) are in the very most majority brought by the precursor layer 5 which contains only few (< 1 %), here none, atoms of silicon. This therefore allows a less complex method wherein only a transition metal can be deposited on the back-side surface of the substrate. No complex and expensive co-deposition of a transition metal with silicon is thus required.

Here, with a precursor layer 5 containing nickel as a transition metal, the different phases that may be formed by the method of the invention are NiSi, Ni₂Si, and NiSi₂.

Advantageously, the laser irradiation parameters may be optimized so as to form different phases of metal-silicide and adjust the fraction of each phase in the metal-silicide layer 8.

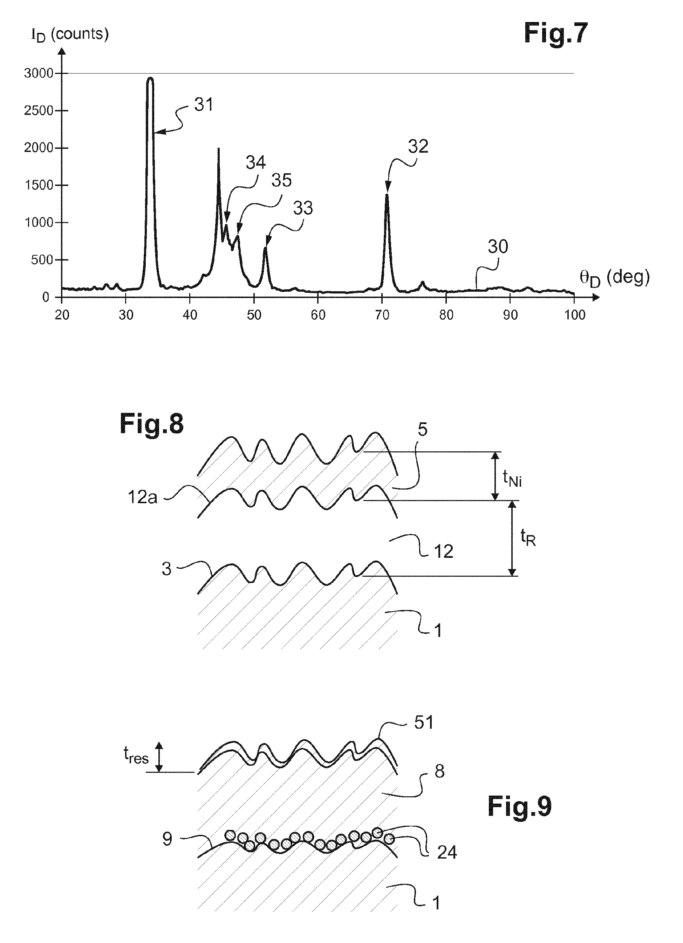

This may be seen in figure 7 which represents a X-ray diffraction (XRD) measurement curve 30 obtained with the silicon carbide substrate 1 covered by the metal-silicide layer 8 formed by the above-detailed method of the invention.

The abscissa corresponds to the diffraction angle θ_{D} in degrees and the ordinate corresponds to the diffraction intensity, measured here in counts (no unit).

The measurement curve 30 presents different diffraction peaks 31, 32, 33, 34, 35:
- peaks 31 and 32 correspond to a background signal, namely the diffraction by the substrate 1 (4H-SiC);
- peak 33 corresponds to the diffraction by the NiSi phase of the silicide layer 8;
- peak 34 corresponds to the diffraction by the Ni₂Si phase; and
- peak 35 corresponds to the diffraction by the NiSi₂ phase.

The advantage of obtaining a silicide layer 8 containing different phases of metal-silicide is that it allows reaching a better conductivity of the silicide layer 8.

After having formed the ohmic contact on the SiC substrate 1 by means of the method of the invention, the process of manufacturing the diode 10 comprises forming a metallic conductive electrode 11 on top of the silicide layer 8 (see figure 5). This electrode 11 functions as a cathode for the diode 10.

In a second embodiment, the method according to the invention comprises, before step a), a step of forming a rough damaged silicon carbide layer 12 (see figure 8) on the back-side surface 3 of the SiC substrate 1.

Indeed, it has been observed that roughness is benefit for the formation of the ohmic contact at the interface 9 between the SiC substrate 1 and the silicide layer 8 (see figure 9). In particular, such ohmic contacts demonstrate reduced contact resistance.

The step of forming the rough damaged SiC layer 12 may comprise grinding the back-side surface 3 of the SiC substrate 1.

The operation of grinding, which is well known in the art of microelectronics, may comprise a rough, medium or fine grinding. Preferably, the step of forming the rough damaged SiC layer 12 comprises a rough grinding operation.

Advantageously, the operation of grinding is part of the thinning process applied to the SiC substrate 1 before the formation of the ohmic contact with the method of the invention.

Depending on the type of back-side grinding, the roughness Rq and the thickness t_{R} of the damaged SiC layer 12 may vary.

The roughness Rq may be defined as the root-mean-squared (RMS) roughness of the surface 12a of the damaged SiC layer 12.

Advantageously, the roughness R_{d} of the damaged SiC layer 12 is below 100 nm, preferably comprise between 1 nm and 80 nm.

As represented in figure 8, the thickness t_{R} of the rough damaged SiC layer 12 corresponds to an average thickness of this layer, that is the thickness measured from the average profile of the surface 12a of the damaged SiC layer 12 to the average profile of the back-side surface 3 of the substrate.

In order to obtain an efficient melting of the damaged SiC layer 12 through the heating by the laser pulse 6, the step of forming this damaged SiC layer 12 is such that the final thickness t_{R} of the damaged SiC layer 12 is comprised between 1 nm and 500 nm, and preferably between 100 nm and 300 nm.

After the step of forming the rough damaged SiC layer 12, and before step b) of irradiation, the precursor layer 5 is deposited on this damaged SiC layer 12, and the precursor layer 5 follows the roughness of the upper surface 12a of the damaged SiC layer 12, filling up the valleys of the surface profile.

Advantageously, the deposited precursor layer 5 has before step b) a thickness t_{Ni} (see figure 8) comprised between 10 and 100 nm, preferably between 50 and 200 nm.

Like for the first embodiment of the method according to the invention, the step of irradiating the precursor layer 5 with the laser pulse 6 causes the whole precursor layer 5 and a superficial layer 7 of the silicon carbide substrate 1 to melt and mix to form the silicide layer 8.

In this case, the superficial layer 7 comprises at least the damaged silicon carbide layer 12.

Additionally, the irradiation parameters of the laser pulse 6 are selected in such a way that the whole damaged SiC layer 12 is molten during step b). These irradiation parameters may also be selected in order to melt the whole damaged SiC layer 12 and a thin part of the SiC substrate 1 close to the back-side surface 3, at the interface with the damaged SiC layer 12.

It has been observed that this method for forming the ohmic contact at the interface 9 between the SiC substrate 1 and the silicide layer 8 present many advantages that lead to better yield and better device performances.

First, the operation of melting and mixing the precursor layer 5 and the superficial layer 7, including the rough damaged SiC layer 12, improves the overall surface contact between the silicide layer 8 and the SiC substrate 1 by filling up non-uniformities of the nickel deposition and SiC cracks generated by the grinding operation at the interface between the damaged SiC layer 12 and the SiC substrate 1. Moreover, as represented in figure 9, a smooth residual layer 51 having a reduced roughness R'q below 50 nm, typically below 10 nm and a residual thickness tᵣₑₛ lower than 10 nm is formed on top of the silicide layer 8. In other cases, this metallic residual layer 51 may not exist, the precursor layer 5 being entirely dissolved in the silicide layer 8.

Second, melting the damaged SiC layer allows recovering a relatively smooth interface 9 between the nickel-silicide layer 8 and the SiC substrate 1.

Third, melting the damaged SiC layer enhances the carbon clusterization at the interface 9 between the nickel-silicide layer 8 and the SiC substrate 1. Indeed, as shown in figure 9, the method according to the invention allows the formation of many carbon clusters 24 (or *"C-clusters"*) at the very close vicinity of the interface 9 between the nickel-silicide layer 8 and the SiC substrate 1.

Those C-clusters 24, which present an average characteristic size comprised between 1 nm and 50 nm depending on the irradiation parameters of the laser pulse 6, especially the laser energy density Fₑ, are relatively uniformly distributed over the interface 9.

It has been observed that C-clusters 24 play a fundamental role in the formation of an ohmic contact with low resistance.

In particular, the contribution of the C-clusters 24 to the reduction of resistivity of the ohmic contact is larger than the contribution originating from the formation of different phases of metal-silicide in the silicide layer 8.

We have represented in figure 11 a silicon carbide wafer 20 designed for the production of power diodes, e.g. Schottky diodes, wherein, before dicing, the wafer 20 comprise different dies 21, 22, 23.

Those dies 21, 22, 23 comprise a SiC substrate, circuitry elements on the front-side surface of this substrate, and a precursor layer deposited on the back-side surface of the substrate.

In order to form a metal-silicide layer for each die 21, 22, 23, the step of irradiating the wafer 20 with a laser pulse 6 comprises irradiating selected regions 61, 62, 63 of the wafer 20, each selected region 61, 62, 63 being irradiated by one respective laser pulse 6.

Advantageously, each irradiated selected regions 61, 62, 63 is adapted to the size of at least one die 21, 22, 23 of the wafer 20.

In a preferred embodiment, two selected regions (e.g. regions 61 and 62, see figure 11) irradiated each by one laser pulse 6 overlap by at most 1%. In other words, the overlapping zone 60 between the two selected regions 61, 62 represents less than 1 % of the surface area of each selected region 61, 62.

This allows a high-throughput method for forming ohmic contact for each die 21, 22, 23 over the whole wafer 20.

The entire wafer 20 is treated by a step-and-repeat process without the need of scanning the laser pulse over the surface of each die which may lead to non-uniformities in the formation of the metal-silicide layer.

Advantageously, in the method of forming an ohmic contact on the SiC substrate of each die 21, 22, 23, the laser pulse 6 presents a geometrical section that corresponds to one respective die 21, 22, 23.

In order to increase production yield, the geometrical section of the laser pulse 6 may even cover more than one die on the wafer 20.

In a particular embodiment, the geometrical section is then greater than 100 mm², preferably greater than 200 mm², allowing to process wafers with size ranging from 4 inches to 8 inches.

In other embodiments, the method further comprises an additional deposition step before step b) wherein at least one additional layer is deposited on top of said precursor layer or between said precursor layer and said back-side surface of the substrate, for example by sputtering or evaporation.

This additional layer may serve as a capping layer to avoid oxidization of the precursor layer when this precursor layer is prone to oxidize itself in presence of moisture or of oxygen contained in ambient air. For example, when the precursor layer is a nickel layer, one can recover the precursor layer with an additional layer of titanium which is known to be insensitive to oxidization.

This additional layer may otherwise serve as a layer to promote adhesion of the precursor layer on the substrate. In this case, the additional layer is deposited on the back-side surface of the substrate before step a), that is before deposition of the precursor layer. When the precursor layer is a nickel layer, the additional layer may be a very thin layer of platinum.

When the additional layer is deposited on top of the precursor layer, it may also function as an *"impedance-matching"* layer, in order to increase transfer of radiant energy from the laser pulse on the back-side of the substrate to the precursor layer and the substrate. In other words, the additional layer may decrease the total reflectivity seen by the laser pulse from the back-side of the substrate. When the precursor layer present a very high reflection at the wavelength of the laser pulse, it is possible to recover the precursor layer with an additional layer having a lower reflectivity in order to avoid unnecessary loss of energy due to high reflection. For example, when the precursor layer is an aluminum layer, which known to have a reflectivity as high as 90% in the UV region around 300 nm, it is possible to deposit a layer of titanium having a low reflectivity value in the UV on top of the aluminum layer.

In the above-described method for forming an ohmic contact on the back-side surface of a silicon carbide substrate, a single laser pulse with optimized irradiation parameters, in particular with high laser energy density, is used to melt a top thin metallic layer containing a transition metal and a superficial layer of the SiC substrate. Melting conditions are achieved by very short laser pulse in the UV region with no overlap and without heating the front-side surface. Melting conditions can be theoretically identified by laser simulation and experimentally monitored during laser processing.

The present invention also concerns a thermal processing system capable of locally heating semiconductor materials and able to melt the top thin metallic layer and partially the SiC substrate. The heating system should provide useful thermal input energy short enough to avoid heat diffusion on the front side of the wafers.

A low-resistivity ohmic contact for nickel deposited on grinded SiC substrate is achieved by using melting laser anneal with low thermal budget. By melting completely nickel and the damaged SiC layer a non-stoichiometric silicide is formed, with a smooth interface, carbon nano-cluster, and excellent recover of damaged SiC layer.

The method of the invention can be used for making other kinds of electronic vertical devices, such as a junction-field-effect transistor (JFET), a metal-oxide semiconductor field-effect transistor (MOSFET), an insulated-gate bipolar transistor (IGBT), or a thyristor.

## Claims

1. Method for forming an ohmic contact on a back-side surface (3) of a silicon carbide substrate (1) comprising the steps of:
a) depositing on said back-side surface (3) a precursor layer (5) containing a transition metal;
b) irradiating said precursor layer (5) with a laser pulse (6) so as to form a silicide layer (8) on the back-side surface (3) of the silicon carbide substrate (1), said ohmic contact being formed at an interface (9) between said silicide layer (8) and said silicon carbide substrate (1),
**characterized in that** the precursor layer (5) deposited in step a) has a molecular content in silicon of at most 1 %, irradiation on the back-side surface (3) of the silicon carbide substrate (1) in step b) causing the whole precursor layer (5) and a superficial layer (7) of silicon carbide substrate (1) to melt and mix to form said silicide layer (8).

2. Method according to claim 1, wherein said precursor layer (5) deposited in step a) has a molecular content in transition metal of at least 99 %.

3. Method according to claim 1 or 2, wherein in step b) the energy density, the pulse duration, and/or the laser wavelength of said laser pulse (6) is/are adjusted to melt said superficial layer (7) of silicon carbide substrate (1) to a pre-determined thickness (t_{SL}).

4. Method according to anyone of claims 1 to 3, comprising measuring a melting depth (dₘₑₗₜ) of the molten precursor and superficial layers (5, 7).

5. Method according to anyone of claims 1 to 4, comprising before step a) a step of forming a rough damaged silicon carbide layer (12) on said back-side surface (3) of the silicon carbide substrate (1), said precursor layer (5) being deposited on said damaged silicon carbide layer (12) and said superficial layer (7) comprising at least said damaged silicon carbide layer (12).

6. Method according to claim 5, wherein the damaged silicon carbide layer (12) has a thickness (t_{R}) comprised between 10 nm and 500 nm, preferably between 100 nm and 300 nm.

7. Method according to claim 5 or 6, wherein the damaged silicon carbide layer (12) has a roughness (Rq) below 100 nm.

8. Method according to anyone of claims 1 to 7, wherein before step b) the deposited precursor layer (5) has a thickness (t_{Ni}) comprised between 10 and 100 nm, preferably between 50 and 200 nm.

9. Method according to anyone of claims 1 to 8, comprising an additional deposition step before step b), wherein at least one additional layer is deposited on top of said precursor layer or between said precursor layer and said back-side surface of the substrate.

10. Method according to anyone of claims 1 to 9, wherein said transition metal enters in the composition of a metallic alloy, the precursor layer being formed by a layer of said metallic alloy.

11. Method according to anyone of claims 1 to 10, wherein the transition metal is nickel.

12. Method according to anyone of claims 1 to 11, wherein the silicide layer (8) formed at the end of step b) is a non-stoichiometric metal-silicide layer.

13. Method according to anyone of claims 1 to 12, wherein the energy density (Fₑ) of said laser pulse (6) is greater than 1 J/cm², preferably greater than 3J/cm².

14. Method according to anyone of claims 1 to 13, wherein the pulse duration (D_{L}) of said laser pulse (6) is comprised between 50 and 200 ns, preferably between 130 and 180 ns.

15. Method according to anyone of claims 1 to 14, wherein the laser wavelength (λ_{L}) of said laser pulse (6) is in the UV, preferably between 250 and 355 nm.

16. Method according to anyone of claims 1 to 15, wherein the laser pulse (6) is irradiated by an excimer laser (13).

17. Method according to anyone of claims 1 to 16, wherein the laser pulse (6) presents a geometrical section (14) greater than 100 mm², preferably greater than 200 mm².

18. Method according to anyone of claims 1 to 17, wherein the step of irradiating said back-side surface (3) comprises irradiating at least two selected regions (61, 62, 63) of said back-side surface (3), each selected region (61, 62, 63) being irradiated by one respective laser pulse (6).

19. Method according to claim 18, wherein the at least two selected regions (61, 62, 63) overlap by at most 1 %.

20. Use of the method according to anyone of claims 1 to 19 for making silicon carbide vertical devices.
